# EUROPEAN PATENT APPLICATION

(11) **EP 3 761 080 A1**
(43) Date of publication of application: **06.01.2021**
(21) Application number: 19777652.9
(22) Date of filing: 26.03.2019
(51) Int. Cl.: G02B 5/20, H01L 33/50

(54) **WAVELENGTH CONVERSION MEMBER, BACKLIGHT UNIT AND IMAGE DISPLAY DEVICE**

(30) Priority: 27.03.2018 WO PCT/JP2018/012582
(71) Applicant: Hitachi Chemical Company, Ltd., Chiyoda-ku, Tokyo 100-6606 (JP)
(72) Inventor: MUKAIGAITO, Kouhei, Tokyo 100-6606 (JP); FUNYU, Shigeaki, Tokyo 100-6606 (JP); TAKAHASHI, Hiroaki, Tokyo 100-6606 (JP); NAKAMURA, Tomoyuki, Tokyo 100-6606 (JP); YAHATA, Tatsuya, Tokyo 100-6606 (JP)
(74) Representative: Berggren Oy, Tampere
(86) International application number: PCT/JP2019/013025
(87) International publication number: WO 2019/189270

(57) **Abstract**

A wavelength conversion member which contains a quantum dot phosphor and is capable of converting incident light into green light and red light, and which is configured such that the half-value width of the green light emission spectrum (FWHM-G) is 30 nm or less.

## Description

### Technical Field

The present disclosure relates to a wavelength conversion member, a backlight unit, and an image display device.

### Background Art

In recent years, in the field of image display devices such as liquid crystal display devices, improvement in color reproducibility of displays has been required, and regarding a means for improving color reproducibility, a wavelength conversion member containing a quantum dot phosphor has been focused on (for example, refer to Patent Literature 1 and 2).

A wavelength conversion member containing a quantum dot phosphor is arranged, for example, in a backlight unit of an image display device. When a wavelength conversion member containing a quantum dot phosphor that emits red light and a quantum dot phosphor that emits green light is used, if blue light as excitation light is emitted to the wavelength conversion member, white light can be obtained from red light and green light emitted from the quantum dot phosphors and blue light that has been transmitted through the wavelength conversion member.

With the development of a wavelength conversion member containing a quantum dot phosphor, the color reproducibility of a display has increased from a conventional National Television System Committee (NTSC) ratio of 72% to an NTSC ratio of 100%. In addition, due to the increasing demands for color reproducibility in recent years, a higher standard than the previous NTSC standard tends to be required. For example, there are increasing demands for higher standards such as Digital Cinema Initiatives (DCI)-P3, and Rec2020.

In what is known as a quantum size effect, the quantum dot phosphor can change various optical properties such as an absorption wavelength and an emission wavelength of light by the size of the quantum dot phosphor being changed itself. It is considered that, by using this property, and appropriately selecting light emission characteristics of the quantum dot phosphor, it is possible to design the obtained white light to have high brightness and excellent color reproducibility.

### Reference List

### Patent Literature

Patent Literature 1: Published Japanese Translation No. 2013-544018 of the PCT International Publication
Patent Literature 2: PCT International Publication No. WO 2016/052625

### Summary of Invention

### Technical Problem

In recent years, an action of regulating the amount of heavy metals used in electronic and electrical devices has spread worldwide. For example, in European Union (EU) countries, the amount of cadmium (Cd) used is limited to 100 ppm or less according to the Restriction on Hazardous Substances (RoHS) directive.

Quantum dot phosphors using Cd are widely used as typical materials for quantum dot phosphors because they have excellent light emission characteristics such as color reproducibility and brightness. Therefore, it can be said that replacing Cd with another material is an effective measure for reducing the amount of Cd used. Indium (In) is desirable as a material that replaces Cd. However, when In is used, it is actually difficult to realize the same color reproducibility and brightness as when Cd is used.

The present disclosure has been made in view of the above circumstances and an objective of the present disclosure is to provide a wavelength conversion member which has excellent balance between color reproducibility and brightness and can reduce the amount of Cd used. In addition, an objective of the present disclosure is to provide a backlight unit and an image display device which have excellent balance between color reproducibility and brightness and can reduce the amount of Cd used.

### Solution to Problem

Specific solutions for addressing the above problem include the following embodiments.
<1> A wavelength conversion member which contains a quantum dot phosphor and is able to convert incident light into green light and red light, in which a half-value width of the green light emission spectrum (FWHM-G) is 30 nm or less.
<2> The wavelength conversion member according to claim 1, wherein the concentration of Cd is 100 ppm or less.
<3> A wavelength conversion member which contains a quantum dot phosphor containing Cd and is able to convert incident light into green light and red light and in which a half-value width of the green light emission spectrum(FWHM-G) is 30 nm or less, and the concentration of Cd is 100 ppm or less.
<4> The wavelength conversion member according to any one of <1> to <3>, wherein the half-value width of a red light emission spectrum (FWHM-R) is 40 nm or more.
<5> The wavelength conversion member according to any one of <1> to <4>, wherein the peak wavelength of the green light emission spectrum is in a range of 530±20 nm, and the peak wavelength of red light emission spectrum is in a range of 630±20 nm.
<6> The wavelength conversion member according to any one of <1> to <5>, wherein the quantum dot phosphor includes a quantum dot phosphor that emits green light and a quantum dot phosphor that emits red light, the quantum dot phosphor that emits green light contains a compound containing Cd, and the quantum dot phosphor that emits red light contains a compound containing In.
<7> The wavelength conversion member according to any one of <1> to <6>, further containing a resin cured product.
<8> The wavelength conversion member according to <7>, further containing a covering material that covers at least a part of the resin cured product.
<9> The wavelength conversion member according to <8>, wherein the covering material has a barrier property against at least one of oxygen and water.
<10> A backlight unit including the wavelength conversion member according to any one of <1> to <9> and a light source.
<11> An image display device including the backlight unit according to <10> Advantageous Effects of Invention

According to the present disclosure, there is provided a wavelength conversion member which has excellent balance between color reproducibility and brightness and can reduce the amount of Cd used. In addition, according to the present disclosure, there are provided a backlight unit and an image display device which have excellent balance between color reproducibility and brightness and can reduce the amount of Cd used.

### Brief Description of Drawings

Fig. 1 is a schematic cross-sectional view showing an example of a schematic configuration of a wavelength conversion member of the present disclosure.
Fig. 2 is a diagram showing an example of a schematic configuration of a backlight unit of the present disclosure.
Fig. 3 is a diagram showing an example of a schematic configuration of a liquid crystal display device of the present disclosure.

### Description of Embodiments

Forms for implementing the present invention will be described below in detail. However, the present invention is not limited to the following embodiments. In the following embodiments, constituent elements (also including elemental steps and the like) are not essential unless otherwise specified. The same applies to numerical values

In the present disclosure, the term "process" includes not only a process independent of other processes but also a process even if the process cannot be clearly distinguished from other processes as long as an objective of the process is achieved.

In the present disclosure, when a numerical range is indicated using "to," it means that numerical values stated before and after "to" are included as a minimum value and a maximum value.

In stepwise numerical ranges described in the present disclosure, an upper limit value or a lower limit value described in one numerical range may be replaced with an upper limit value or a lower limit value of other described stepwise numerical ranges. In addition, in the numerical ranges described in the present disclosure, the upper limit value or the lower limit value of the numerical range may be replaced with values shown in examples.

In the present disclosure, each component may contain a plurality of corresponding substances. When there are a plurality of types of substances corresponding to each component in the composition, a content of each component means a total content of the plurality of types of substances present in the composition unless otherwise noted.

In the present disclosure, a plurality of types of particles corresponding to each component may be included. When there are a plurality of types of particles corresponding to each component in the composition, the particle size of each component means a value for a mixture including the plurality of types of particles present in the composition unless otherwise noted.

In the present disclosure, the term "layer" or "film" means, when a region in which the layer or film is present is observed, not only a case in which it is formed over the entire region but also a case in which it is formed only in a part of the region.

In the present disclosure, the term "laminating" refers to laminating layers, combining two or more layers, or two or more layers that are removable.

In the present disclosure, the average thickness of the laminate or layers constituting the laminate is an arithmetic average value of thicknesses at three arbitrary points measured using a micrometer or the like.

In the present disclosure, "(meth)acryloyl group" refers to at least one of an acryloyl group and a methacryloyl group, "(meth)acrylic" refers to at least one of acrylic and methacrylic, "(meth)acrylate" refers to at least one of acrylate and methacrylate, and "(meth)allyl" refers to at least one of allyl and methallyl.

In the present disclosure, a (meth)allyl compound refers to a compound containing a (meth)allyl group in a molecule, and a (meth)acrylic compound refers to a compound containing a (meth)acryloyl group in a molecule.

### <Wavelength conversion member>

A wavelength conversion member of the present disclosure contains a quantum dot phosphor and is able to convert incident light into green light and red light, in which a half-value width of the green light emission spectrum (FWHM-G) is 30 nm or less.

In the wavelength conversion member of the present disclosure, when the half-value width of the green light emission spectrum (FWHM-G) is set to be in a specific range, it is possible to reduce the amount of Cd used while maintaining favorable balance between color reproducibility and brightness.

In the present disclosure, "half-value width of an emission spectrum" means a width of the emission spectrum in which the height of the peak of the emission spectrum is 1/2, and means a full width at half maximum (FWHM).

A method of determining a half-value width of an emission spectrum is not particularly limited, and known methods can be used. For example, it can be calculated from an emission spectrum measured using a brightness meter.

The reason why it is possible to reduce the amount of Cd used while maintaining favorable balance between color reproducibility and brightness when the half-value width of the green light emission spectrum (FWHM-G) is set to 30 nm or less is speculated to be as follows.

When the half-value width of the emission wavelength due to the quantum dot phosphor is smaller (the width of the emission wavelength peak is narrower), the color purity is higher and the color reproducibility is improved. When the half-value width is larger, the color reproducibility deteriorates, but green light is more greatly influenced than red light. However, on the other hand, when the half-value width is smaller, decrease in brightness tends to occur due to a shift of the position of the peak and the like.

In addition, red light has less influence on the color reproducibility according to the half-value width than green light. Therefore, even if the half-value width is relatively widened, decrease in brightness can be minimized without significantly deteriorating color reproducibility as compared with green light.

Focusing on this trend, in the wavelength conversion member of the present disclosure, the color reproducibility is improved when the width of the emission wavelength peak of green light rather than red light is set to 30 nm or less, and when decrease in brightness as a whole is minimized, excellent balance between color reproducibility and brightness as a whole is achieved.

In addition, when there is no limitation on the half-value width of the emission wavelength peak of red light, it is possible to use a material that replaces Cd. For example, in a quantum dot phosphor using In, it is difficult to control the emission wavelength, and it is difficult to obtain the same color reproducibility and brightness as when Cd is used. However, when the half-value width of the emission wavelength peak of green light is set to 30 nm or less, even if Cd in the quantum dot phosphor that emits red is replaced with In, favorable balance between favorable color reproducibility and brightness as a whole is maintained. As a result, it is possible to reduce the amount of Cd used in the wavelength conversion member. Alternatively, the amount of the quantum dot phosphor itself required for emitting green light is reduced by setting the half-value width of the emission wavelength peak of green light to 30 nm or less, and it is possible to reduce the amount of Cd used in the wavelength conversion member.

In addition, examples of an advantage obtained by making the half-value width of the emission wavelength peak of green light to 30 nm or less include that, by making the edge on the shorter wavelength side of the emission wavelength peak of green light be further away from the emission wavelength peak of blue light positioned on the shorter wavelength side than thereof, a phenomenon in which the quantum dot phosphor converts incident blue light and the quantum dot phosphor reabsorbs the obtained light is inhibited and decrease in conversion efficiency is minimized.

The concentration of Cd in the wavelength conversion member of the present disclosure may be, for example, 100 ppm or less. The lower limit value of the concentration of Cd is not particularly limited, and may be, for example, 10 ppm or more. The concentration of Cd in the wavelength conversion member can be measured according to, for example, an ICP-OES method (inductively coupled plasma optical emission spectroscopy).

The half-value width of the green light emission spectrum converted by the wavelength conversion member of the present disclosure is not particularly limited as long as it is 30 nm or less, and in order to improve the color reproducibility, it is more preferably 25 nm or less. On the other hand, in order to minimize decrease in brightness, the half-value width of the green light emission spectrum is preferably 20 nm or more.

The wavelength of green light converted by the wavelength conversion member of the present disclosure is not particularly limited, and it is preferable that the peak of the emission spectrum be in a range of 530±20 nm.

The half-value width of the red light emission spectrum converted by the wavelength conversion member of the present disclosure is not particularly limited, and in order to improve the color reproducibility, it is preferably 50 nm or less and more preferably 47 nm or less. On the other hand, in order to minimize decrease in brightness, the half-value width is preferably 40 nm or more and more preferably 42 nm or more.

The wavelength of red light converted by the wavelength conversion member of the present disclosure is not particularly limited, and it is preferable that the peak of the emission spectrum be in a range of 630±20 nm.

A ratio (FWHM-G)/(FWHM-R) of the half-value width of the green light emission spectrum (FWHM-G) to the half-value width of the red light emission spectrum (FWHM-R) is not particularly limited, and from the viewpoint of the balance between color reproducibility and brightness, the ratio is preferably 0.70 or less, more preferably 0.65 or less, still more preferably 0.60 or less, yet more preferably 0.55 or less, and most preferably 0.50 or less.

From the viewpoint of balance between color reproducibility and brightness, a ratio (FWHM-G)/(FWHM-R) of the half-value width of the green light emission spectrum (FWHM-G) to the half-value width of the red light emission spectrum (FWHM-R) is preferably 0.40 or more, more preferably 0.45 or more, and still more preferably 0.50 or more.

A method of adjusting emission wavelengths and half-value widths of emission spectrums of green light and red light converted by the wavelength conversion member is not particularly limited. For example, adjustment can be performed according to the material, particle size, particle size distribution, and core-shell structure state of the quantum dot phosphor contained in the wavelength conversion member. The quantum dot phosphor that emits green light and the quantum dot phosphor that emits red light, which are contained in the wavelength conversion member each may be of one type or of two or more types in combination in which at least one of the above items is different.

Specific examples of quantum dot phosphors include particles of compounds including at least one selected from the group consisting of Group II-VI compounds, Group III-V compounds, Group IV-VI compounds, and Group IV compounds. From the viewpoint of luminous efficiency, the quantum dot phosphor preferably contains a compound containing at least one of Cd and In. Among these, regarding the quantum dot phosphor using Cd, one using CaSe is preferable, and regarding the quantum dot phosphor using In, one using InP is preferable.

In some embodiments, the quantum dot phosphor that emits green light contains a compound containing Cd, and the quantum dot phosphor that emits red light contains a compound containing In. In addition, in some embodiments, the quantum dot phosphor that emits green light contains CdSe and the quantum dot phosphor that emits red light contains InP.

Specific examples of Group II-VI compounds include CdSe, CdTe, CdS, ZnS, ZnSe, ZnTe, ZnO, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, CdZnSeS, CdZnSeTe, CdZnSTe, CdHgSeS, CdHgSeTe, CdHgSTe, HgZnSeS, HgZnSeTe, and HgZnSTe.

Specific examples of Group III-V compounds include GaN, GaP, GaAs, GaSb, AlN, AlP, AlAs, AlSb, InN, InP, InAs, InSb, GaNP, GaNAs, GaNSb, Ga PAs, GaPSb, AlNP, AINAs, AINSb, AlPAs, AlPSb, InNP, InNAs, InNSb, In PAs, InPSb, GaAlNP, GaAlNAs, GaAlNSb, GaAl PAs, GaAlPSb, GaInNP, GaInNAs, GaInNSb, GaIn PAs, GaInPSb, InAlNP, InAlNAs, InAlNSb, InAl PAs, and InAlPSb.

Specific examples of Group IV-VI compounds include SnS, SnSe, SnTe, PbS, PbSe, PbTe, SnSeS, SnSeTe, SnSTe, PbSeS, PbSeTe, PbSTe, SnPbS, SnPbSe, SnPbTe, SnPbSSe, SnPbSeTe, and SnPbSTe.

Specific examples of Group IV compounds include Si, Ge, SiC, and SiGe.

The quantum dot phosphor may have a core-shell structure. By setting the band gap of the compound constituting the shell to be wider than the band gap of the compound constituting the core, it is possible to further improve quantum efficiency of the quantum dot phosphor. Examples of combinations of a core and a shell (core/shell) include CdSe/ZnS, InP/ZnS, PbSe/PbS, CdSe/CdS, CdTe/CdS, and CdTe/ZnS.

The quantum dot phosphor may have a so-called core multi-shell structure in which the shell has a multi-layer structure. By laminating one layer or two or more layers of a shell having a narrow band gap on a core having a wide band gap, and additionally, laminating a shell having a wide band gap on the shell, it is possible to further improve quantum efficiency of the quantum dot phosphor.

When the wavelength conversion member contains a quantum dot phosphor, two or more types of quantum dot phosphors having different components, average particle sizes, layered structures and the like may be combined. When two or more types of quantum dot phosphors are combined, the emission center wavelength of the wavelength conversion member as a whole can be adjusted to a desired value.

The quantum dot phosphor may include a quantum dot phosphor that emits blue light in addition to the quantum dot phosphor that emits green light and the quantum dot phosphor that emits red light.

The quantum dot phosphor may be used in a dispersion state in which it is dispersed in a dispersion medium. Examples of dispersion mediums in which the quantum dot phosphor is dispersed include various organic solvents, silicone compounds and monofunctional (meth)acrylate compounds.

The organic solvent that can be used as the dispersion medium is not particularly limited as long as precipitation and aggregation of the quantum dot phosphor are not confirmed, and examples thereof include acetonitrile, methanol, ethanol, acetone, 1-propanol, ethyl acetate, butyl acetate, toluene, and hexane.

Examples of silicone compounds that can be used as the dispersion medium include straight silicone oils such as dimethyl silicone oil, methylphenyl silicone oil, and methyl hydrogen silicone oil; and modified silicone oils such as amino modified silicone oil, epoxy modified silicone oil, carboxy modified silicone oil, carbinol modified silicone oil, mercapto modified silicone oil, a different functional group modified silicone oil, polyether modified silicone oil, methylstyryl modified silicone oil, hydrophilic special modified silicone oil, higher alkoxy modified silicone oil, higher fatty acid modified silicone oil, and fluorine modified silicone oil.

The monofunctional (meth)acrylate compound that can be used as the dispersion medium is not particularly limited as long as it is a liquid at room temperature (25°C), and examples thereof include a monofunctional (meth)acrylate compound having an alicyclic structure, and preferably, isobornyl (meth)acrylate and dicyclopentanyl (meth)acrylate, methoxy polyethylene glycol (meth)acrylate, phenoxy polyethylene glycol (meth)acrylate, and ethoxylated o-phenylphenol (meth)acrylate.

The dispersion may contain a dispersant as necessary. Examples of dispersants include a polyether amine (JEFFAMINE M-1000, commercially available from HUNTSMAN).

The dispersion medium in which the quantum dot phosphor is dispersed may or may not be phase-separated from other components contained in the quantum dot phosphor. For example, when a silicone compound is used as the dispersion medium in which the quantum dot phosphor is dispersed and a polymerizable compound to be described below is used in combination, a structure in which the silicone compound is phase-separated and dispersed in a droplet form can be formed in the cured product of the polymerizable compound.

For example, the content of the quantum dot phosphor in the wavelength conversion member is preferably 0.01 mass% to 1.0 mass%, more preferably 0.05 mass% to 0.5 mass%, and still more preferably 0.1 mass% to 0.5 mass% with respect to the entire wavelength conversion member (excluding a covering material and the like when the covering material and the like are further included). When the content of the quantum dot phosphor is 0.01 mass% or more, a sufficient wavelength conversion function tends to be obtained, and when the content of the quantum dot phosphor is 1.0 mass% or less, aggregation of the quantum dot phosphor tends to be minimized.

### (Resin cured product)

The wavelength conversion member may further contain a resin cured product, and the quantum dot phosphor may be contained in a resin cured product. The resin cured product may be obtained by, for example, curing a composition (resin composition) containing a quantum dot phosphor, a polymerizable compound, and a photopolymerization initiator.

From the viewpoint of adhesion of the resin cured product to other members (the covering material and the like) and minimizing the occurrence of wrinkles due to volume shrinkage during curing, the resin cured product preferably has a sulfide structure.

The resin cured product having a sulfide structure can be obtained by, for example, curing a resin composition containing a thiol compound to be described below and a polymerizable compound having a carbon-carbon double bond that causes an ene-thiol reaction with a thiol group of the thiol compound.

From the viewpoint of the heat resistance and the moisture and heat resistance of the wavelength conversion member, the resin cured product preferably has an alicyclic structure or an aromatic ring structure.

The resin cured product having an alicyclic structure or an aromatic ring structure can be obtained by, for example, curing a resin composition containing those having an alicyclic structure or an aromatic ring structure as a polymerizable compound to be described below.

In order to inhibit contact between the quantum dot phosphor and oxygen, the resin cured product preferably contains an alkyleneoxy group. When the resin cured product contains an alkyleneoxy group, the polarity of the resin cured product increases, and non-polar oxygen is unlikely to be dissolved in the components in the cured product. In addition, the flexibility of the resin cured product increases and the adhesion with respect to the covering material tends to be improved.

The resin cured product containing an alkyleneoxy group can be obtained by, for example, curing a resin composition containing those having an alkyleneoxy group as a polymerizable compound to be described below.

The polymerizable compound contained in the resin composition is not particularly limited, and examples thereof include a thiol compound, a (meth)acrylic compound, and a (meth)allyl compound.

From the viewpoint of adhesion of the resin cured product to other members (the covering material and the like), the resin composition preferably contains a thiol compound as a polymerizable compound and at least one selected from the group consisting of a (meth)acrylic compound and a (meth)allyl compound.

The resin cured product obtained by curing a resin composition containing a thiol compound as a polymerizable compound and at least one selected from the group consisting of a (meth)acrylic compound and a (meth)allyl compound has a sulfide structure (R-S-R', R and R' represent an organic group) that is formed when an ene-thiol reaction occurs between a thiol group and a carbon-carbon double bond of a (meth)acryloyl group or a (meth)allyl group. Therefore, the adhesion between the resin cured product and the covering material tends to be improved. In addition, optical properties of the resin cured product tend to be further improved.

### (1) Thiol compound

he thiol compound may be a monofunctional thiol compound having one thiol group in one molecule or a multifunctional thiol compound having two or more thiol groups in one molecule. The thiol compound contained in the resin composition may be of one type or two or more types.

he thiol compound may or may not have a polymerizable group (for example, a (meth)acryloyl group and a (meth)allyl group) other than the thiol group in a molecule.

n the present disclosure, a compound containing a thiol group and a polymerizable group other than the thiol group in a molecule is classified as a "thiol compound."

Specific examples of monofunctional thiol compounds include hexanethiol, 1-heptanethiol, 1-octanethiol, 1-nonanethiol, 1-decanethiol, 3-mercaptopropionic acid, methyl mercaptopropionate, methoxybutyl mercaptopropionate, octyl mercaptopropionate, tridecyl mercaptopropionate, 2-ethylhexyl-3-mercaptopropionate, and n-octyl-3 -mercaptopropionate.

Specific examples of multifunctional thiol compounds include ethylene glycol bis(3-mercaptopropionate), diethylene glycol bis(3-mercaptopropionate), tetraethylene glycol bis(3-mercaptopropionate), 1,2-propylene glycol bis(3-mercaptopropionate), diethylene glycol bis(3-mercaptobutyrate), 1,4-butanediol bis(3-mercaptopropionate), 1,4-butanediol bis(3-mercaptobutyrate), 1,8-octanediol bis(3-mercaptopropionate), 1,8-octanediol bis(3-mercaptobutyrate), hexanediol bisthioglycolate, trimethylolpropane tris(3-mercaptopropionate), trimethylolpropane tris(3-mercaptobutyrate), trimethylolpropane tris(3 -mercaptoisobutyrate), trimethylolpropane tris(2-mercaptoisobutyrate), trimethylolpropane tristhioglycolate, tris-[(3 -mercaptopropionyloxy)-ethyl] -isocyanurate, trimethylol ethane tris(3-mercaptobutyrate), pentaerythritol tetrakis(3-mercaptopropionate), pentaerythritol tetrakis(3-mercaptobutyrate), pentaerythritol tetrakis(3-mercaptoisobutyrate), pentaerythritol tetrakis(2-mercaptoisobutyrate), dipentaerythritol hexakis(3-mercaptopropionate), dipentaerythritol hexakis(2-mercaptopropionate), dipentaerythritol hexakis(3-mercaptobutyrate), dipentaerythritol hexakis(3-mercaptoisobutyrate), dipentaerythritol hexakis(2-mercaptoisobutyrate), pentaerythritol tetrakis thioglycolate, and dipentaerythritol hexakis thioglycolate.

In order to further improve the adhesion between the resin cured product and the covering material, heat resistance, and moisture and heat resistance, the thiol compound preferably contains a multifunctional thiol compound. A proportion of the multifunctional thiol compound with respect to a total amount of the thiol compound is, for example, preferably 80 mass% or more, more preferably 90 mass% or more, and still more preferably 100 mass%.

The thiol compound may be in a state of a thioether oligomer reacted with a (meth)acrylic compound. The thioether oligomer can be obtained by addition polymerization of a thiol compound and a (meth)acrylic compound in the presence of a polymerization initiator.

When the resin composition contains a thiol compound, the content of the thiol compound in the resin composition with respect to a total amount of the resin composition is, for example, preferably 5 mass% to 80 mass%, more preferably 15 mass% to 70 mass%, and still more preferably 20 mass% to 60 mass%.

When the content of the thiol compound is 5 mass% or more, the adhesion of the resin cured product to the covering material tends to be further improved, and when the content of the thiol compound is 80 mass% or less, the heat resistance and moisture and heat resistance of the resin cured product tend to be further improved.

### (2) (Meth)acrylic compound

The (meth)acrylic compound may be a monofunctional (meth)acrylic compound having one (meth)acryloyl group in one molecule or a multifunctional (meth)acrylic compound having two or more (meth)acryloyl groups in one molecule. The (meth)acrylic compound contained in the resin composition may be of one type or two or more types.

Specific examples of monofunctional (meth)acrylic compounds include (meth)acrylic acid; alkyl (meth)acrylates containing an alkyl group having 1 to 18 carbon atoms such as methyl (meth)acrylate, n-butyl (meth)acrylate, isobutyl (meth)acrylate, 2-ethylhexyl (meth)acrylate, isononyl (meth)acrylate, n-octyl (meth)acrylate, lauryl (meth)acrylate, and stearyl (meth)acrylate; (meth)acrylate compounds having an aromatic ring such as benzyl (meth)acrylate and phenoxyethyl (meth)acrylate; alkoxyalkyl (meth)acrylates such as butoxyethyl (meth)acrylate; aminoalkyl (meth)acrylates such as N,N-dimethylaminoethyl (meth)acrylate; polyalkylene glycol monoalkyl ether (meth)acrylates such as diethylene glycol monoethyl ether (meth)acrylate, triethylene glycol monobutyl ether (meth)acrylate, tetraethylene glycol monomethyl ether (meth)acrylate, hexaethylene glycol monomethyl ether (meth)acrylate, octaethylene glycol monomethyl ether (meth)acrylate, nonaethylene glycol monomethyl ether (meth)acrylate, dipropylene glycol monomethyl ether (meth)acrylate, heptapropylene glycol monomethyl ether (meth)acrylate, and tetraethylene glycol monoethyl ether (meth)acrylate; polyalkylene glycol monoaryl ether (meth)acrylates such as hexaethylene glycol monophenyl ether (meth)acrylate; (meth)acrylate compounds having an alicyclic structure such as cyclohexyl (meth)acrylate, dicyclopentanyl (meth)acrylate, isobornyl (meth)acrylate, and methylene oxide-added cyclodecatriene (meth)acrylate; (meth)acrylate compounds having a heterocycle such as (meth)acryloylmorpholine and tetrahydrofurfuryl (meth)acrylate; fluorinated alkyl (meth)acrylates such as heptadecafluorodecyl (meth)acrylate; (meth)acrylate compounds having a hydroxyl group such as 2-hydroxyethyl (meth)acrylate, 3-hydroxypropyl (meth)acrylate, 4-hydroxybutyl (meth)acrylate, triethylene glycol mono(meth)acrylate, tetraethylene glycol mono(meth)acrylate, hexaethylene glycol mono(meth)acrylate, and octapropylene glycol mono(meth)acrylate; (meth)acrylate compounds having a glycidyl group such as glycidyl (meth)acrylate; (meth)acrylate compounds having an isocyanate group such as 2-(2-(meth)acryloyloxyethyloxy)ethyl isocyanate, and 2-(meth)acryloyloxyethyl isocyanate; polyalkylene glycol mono(meth)acrylates such as tetraethylene glycol mono(meth)acrylate, hexaethylene glycol mono(meth)acrylate, and octapropylene glycol mono(meth)acrylate; and (meth)acrylamide compounds such as (meth)acrylamide, N,N-dimethyl (meth)acrylamide, N-isopropyl (meth)acrylamide, N,N-dimethylaminopropyl (meth)acrylamide, N,N-diethyl (meth)acrylamide, and 2-hydroxyethyl (meth)acrylamide.

Specific examples of multifunctional (meth)acrylic compounds include alkylene glycol di(meth)acrylates such as 1,4-butanediol di(meth)acrylate, 1,6-hexanediol di(meth)acrylate, and 1,9-nonanediol di(meth)acrylate; polyalkylene glycol di(meth)acrylates such as polyethylene glycol di(meth)acrylate, and polypropylene glycol di(meth)acrylate; tri(meth)acrylate compounds such as trimethylolpropane tri(meth)acrylate, ethylene oxide-added trimethylolpropane tri(meth)acrylate, and tris(2-acryloyloxyethyl)isocyanurate; tetra(meth)acrylate compounds such as ethylene oxide-added pentaerythritol tetra(meth)acrylate, trimethylolpropane tetra(meth)acrylate, and pentaerythritol tetra(meth)acrylate; and (meth)acrylate compounds having an alicyclic structure such as tricyclodecane dimethanol di(meth)acrylate, cyclohexanedimethanol di(meth)acrylate, 1,3-adamantane dimethanol di(meth)acrylate, hydrogenated bisphenol A (poly)ethoxydi(meth)acrylate, hydrogenated bisphenol A (poly)propoxydi(meth)acrylate, hydrogenated bisphenol F (poly)ethoxydi(meth)acrylate, hydrogenated bisphenol F (poly)propoxydi(meth)acrylate, hydrogenated bisphenol S (poly)ethoxydi(meth)acrylate, and hydrogenated bisphenol S (poly)propoxydi(meth)acrylate.

In order to further improve heat resistance and moisture and heat resistance of the resin cured product, the (meth)acrylic compound is preferably a (meth)acrylate compound having an alicyclic structure or an aromatic ring structure. Examples of alicyclic structures or aromatic ring structures include an isobornyl skeleton, a tricyclodecane skeleton, and a bisphenol skeleton.

The (meth)acrylic compound may be a compound having an alkyleneoxy group or a bifunctional (meth)acrylic compound having an alkyleneoxy group.

Regarding the alkyleneoxy group, for example, an alkyleneoxy group having 2 to 4 carbon atoms is preferable, an alkyleneoxy group having 2 or 3 carbon atoms is more preferable, and an alkyleneoxy group having 2 carbon atoms is still more preferable.

The alkyleneoxy group contained in the (meth)acrylic compound may be of one type or two or more types.

The alkyleneoxy group-containing compound may be a polyalkyleneoxy group-containing compound having a polyalkyleneoxy group containing a plurality of alkyleneoxy groups.

When the (meth)acrylic compound contains an alkyleneoxy group, the number of alkyleneoxy groups in one molecule is preferably 2 to 30, more preferably 2 to 20, still more preferably 3 to 10, and particularly preferably 3 to 5.

When the (meth)acrylic compound contains an alkyleneoxy group, it preferably has a bisphenol structure. Therefore, the heat resistance of the resin cured product tends to be better. Examples of bisphenol structures include a bisphenol A structure and a bisphenol F structure, and among these, a bisphenol A structure is preferable.

Specific examples of (meth)acrylic compounds containing an alkyleneoxy group include alkoxyalkyl (meth)acrylates such as butoxyethyl (meth)acrylate; polyalkylene glycol monoalkyl ether (meth)acrylates such as diethylene glycol monoethyl ether (meth)acrylate, triethylene glycol monobutyl ether (meth)acrylate, tetraethylene glycol monomethyl ether (meth)acrylate, hexaethylene glycol monomethyl ether (meth)acrylate, octaethylene glycol monomethyl ether (meth)acrylate, nonaethylene glycol monomethyl ether (meth)acrylate, dipropylene glycol monomethyl ether (meth)acrylate, heptapropylene glycol monomethyl ether (meth)acrylate, and tetraethylene glycol monoethyl ether (meth)acrylate; polyalkylene glycol monoaryl ether (meth)acrylates such as hexaethylene glycol monophenyl ether (meth)acrylate; (meth)acrylate compounds having a heterocycle such as tetrahydrofurfuryl (meth)acrylate; (meth)acrylate compounds having a hydroxyl group such as triethylene glycol mono(meth)acrylate, tetraethylene glycol mono(meth)acrylate, hexaethylene glycol mono(meth)acrylate, and octapropylene glycol mono(meth)acrylate; (meth)acrylate compounds having a glycidyl group such as glycidyl (meth)acrylate; polyalkylene glycol di(meth)acrylates such as polyethylene glycol di(meth)acrylate, and polypropylene glycol di(meth)acrylate; tri(meth)acrylate compounds such as ethylene oxide-added trimethylolpropane tri(meth)acrylate; tetra(meth)acrylate compounds such as ethylene oxide-added pentaerythritol tetra(meth)acrylate; and bisphenol type di(meth)acrylate compounds such as ethoxylated bisphenol A type di(meth)acrylate, propoxylated bisphenol A type di(meth)acrylate, and ethoxylated bisphenol A type di(meth)acrylate.

Regarding the alkyleneoxy group-containing compound, among these, ethoxylated bisphenol A type di(meth)acrylate, propoxylated bisphenol A type di(meth)acrylate and ethoxylated bisphenol A type di(meth)acrylate are preferable, and ethoxylated bisphenol A type di(meth)acrylate is more preferable.

When the resin composition contains a (meth)acrylic compound, the content of the (meth)acrylic compound in the resin composition with respect to a total amount of the resin composition may be, for example, 40 mass% to 90 mass% or 50 mass% to 80 mass%.

### (3) (Meth)allyl compound

The (meth)allyl compound may be a monofunctional (meth)allyl compound having one (meth)allyl group in one molecule or a multifunctional (meth)allyl compound having two or more (meth)allyl groups in one molecule. The (meth)allyl compound contained in the resin composition may be of one type or two or more types.

The (meth)allyl compound may or may not have a polymerizable group (for example, a (meth)acryloyl group) other than the (meth)allyl group in a molecule.

In the present disclosure, a compound having a polymerizable group other than a (meth)allyl group in a molecule (where a thiol compound is excluded) is classified as a "(meth)allyl compound."

Specific examples of monofunctional (meth)allyl compounds include (meth)allyl acetate, (meth)allyl n-propionate, (meth)allylbenzoate, (meth)allylphenylacetate, (meth)allylphenoxyacetate, (meth)allyl methyl ether, and (meth)allyl glycidyl ether.

Specific examples of multifunctional (meth)allyl compounds include benzene dicarboxylate di(meth)allyl, cyclohexanedicarboxylate di(meth)allyl, di(meth)allyl maleate, di(meth)allyl adipate, di(meth)allyl phthalate, di(meth)allyl isophthalate, di(meth)allyl terephthalate, glycerin di(meth)allyl ether, trimethylolpropane di(meth)allyl ether, pentaerythritol di(meth)allyl ether, 1,3-di(meth)allyl-5-glycidyl isocyanurate, tri(meth)allyl cyanurate, tri(meth)allyl isocyanurate, tri(meth)allyl trimellitate, tetra(meth)allyl pyromellitate, 1,3,4,6-tetra(meth)allylglycoluril, 1,3,4,6-tetra(meth)allyl-3a-methylglycoluril, and 1,3,4,6-tetra(meth)allyl-3a,6a-dimethylglycoluril.

From the viewpoint of heat resistance and moisture and heat resistance of the resin cured product, the (meth)allyl compound is preferably at least one selected from the group consisting of a compound having an isocyanurate skeleton such as tri(meth)allyl isocyanurate, tri(meth)allyl cyanurate, di(meth)allyl benzenedicarboxylate, and di(meth)allyl cyclohexanedicarboxylate, more preferably a compound having an isocyanurate skeleton, and still more preferably tri(meth)allyl isocyanurate.

When the resin composition contains a (meth)allyl compound, the content of the (meth)allyl compound in the resin composition with respect to a total amount of the resin composition may be, for example, 10 mass% to 50 mass%, or 15 mass% to 45 mass%.

In some embodiments, the polymerizable compound may contain a thioether oligomer as a thiol compound and a (meth)allyl compound (preferably a multifunctional (meth)allyl compound).

When the polymerizable compound contains a thioether oligomer as a thiol compound and a (meth)allyl compound, the quantum dot phosphor used in combination is preferably in a dispersion state in which it is dispersed in a silicone compound as a dispersion medium.

In some embodiments, the polymerizable compound may contain a thiol compound that is not in a thioether oligomer state and a (meth)acrylic compound (preferably a multifunctional (meth)acrylic compound, and more preferably a bifunctional (meth)acrylic compound).

When the polymerizable compound contains a thiol compound that is not in a thioether oligomer state and a (meth)acrylic compound, the wavelength conversion material used in combination is preferably in a dispersion state in which it is dispersed in a (meth)acrylic compound as a dispersion medium, preferably in a monofunctional (meth)acrylic compound, and more preferably in an isobornyl (meth)acrylate.

### (Photopolymerization initiator)

The photopolymerization initiator contained in the resin composition is not particularly limited, and examples thereof include a compound that generates radicals according to emission of active energy rays such as UV rays.

Specific examples of photopolymerization initiators include aromatic ketone compounds such as benzophenone, N,N'-tetraalkyl-4,4'-diaminobenzophenone, 2-benzyl-2-dimethylamino-1-(4-morpholinophenyl)-butanone-1,2-methyl-1-[4-(methylth io)phenyl]-2-morpholino-propanone-1,4,4'-bis(dimethylamino)benzophenone (also referred to as "Michler's ketone"), 4,4'-bis(diethylamino)benzophenone, 4-methoxy-4' -dimethylaminobenzophenone, 1-hydroxycyclohexyl phenyl ketone, 1 -(4-isopropylphenyl)-2-hydroxy-2-methylpropan-1 -one, 1 -(4-(2-hydroxyethoxy)-phenyl)-2-hydroxy-2-methyl-1-propan-1-one, and 2-hydroxy-2-methyl-1-phenylpropan-1-one; quinone compounds such as alkylanthraquinone and phenanthrenequinone; benzoin compounds such as benzoin and alkylbenzoin; benzoin ether compounds such as benzoin alkyl ether and benzoin phenyl ether; benzyl derivatives such as benzyl dimethyl ketal; 2,4,5-triarylimidazole dimers such as 2-(o-chlorophenyl)-4,5-diphenylimidazole dimer, 2-(o-chlorophenyl)-4, 5-di(m-methoxyphenyl)imidazole dimer, 2-(o-fluorophenyl)-4,5-diphenylimidazole dimer, 2-(o-methoxyphenyl)-4,5-diphenylimidazole dimer, 2,4-di(p-methoxyphenyl)-5-phenylimidazole dimer, and 2-(2,4-dimethoxyphenyl)-4,5-diphenylimidazole dimer; acridine derivatives such as 9-phenylacridine and 1,7-(9,9'-acridinyl)heptane; oxime ester compounds such as 1,2-octanedione 1-[4-(phenylthio)-2-(O-benzoyloxime)], and ethanone 1-[9-ethyl-6-(2-methylbenzoyl)-9H-carbazol-3-yl]-1-(O-acetyloxime); coumarin compounds such as 7-diethylamino-4-methylcoumarin; thioxanthone compounds such as 2,4-diethylthioxanthone; and acylphosphine oxide compounds such as 2,4,6-trimethylbenzoyl-diphenyl-phosphine oxide, and 2,4,6-trimethylbenzoyl-phenyl-ethoxy-phosphine oxide. The resin composition may contain single type of photopolymerization initiator or may contain two or more types of photopolymerization initiators in combination.

From the viewpoint of curability, the photopolymerization initiator is preferably at least one selected from the group consisting of acylphosphine oxide compounds, aromatic ketone compounds, and oxime ester compounds, more preferably at least one selected from the group consisting of acylphosphine oxide compounds and aromatic ketone compounds, and still more preferably an acylphosphine oxide compound.

The content of the photopolymerization initiator in the resin composition with respect to a total amount of the resin composition is, for example, preferably 0.1 mass% to 5 mass%, more preferably 0.1 mass% to 3 mass%, and still more preferably 0.1 mass% to 1.5 mass%. When the content of the photopolymerization initiator is 0.1 mass% or more, the sensitivity of the resin composition tends to be sufficient, and when the content of the photopolymerization initiator is 5 mass% or less, the influence of the resin composition on the hue and decrease in the storage stability tend to be minimized.

### (Other components)

The resin composition may further contain other components such as a liquid medium (an organic solvent and the like), a polymerization inhibitor, a silane coupling agent, a surfactant, an adhesion imparting agent, and an antioxidant. The resin composition may contain single type of each of other components or two or more types thereof in combination.

### (Light diffusion material)

In order to improve light conversion efficiency, the wavelength conversion member may further contain a light diffusion material.

Specific examples of light diffusion materials include titanium oxide, barium sulfate, zinc oxide, and calcium carbonate. Among these, titanium oxide is preferable from the viewpoint of light scattering efficiency. The titanium oxide may be a rutile type titanium oxide or an anatase type titanium oxide, but is preferably a rutile type titanium oxide.

The average particle size of the light diffusion material is preferably 0.1 µm to 1 µm, more preferably 0.2 µm to 0.8 µm, and still more preferably 0.2 µm to 0.5 µm.

In the present disclosure, the average particle size of the light diffusion material can be measured as follows.

When the light diffusion material is contained in the resin composition, the extracted light diffusion material is dispersed in purified water containing a surfactant to obtain a dispersion. In a volume-based particle size distribution measured using this dispersion by a laser diffraction type particle size distribution measurement device (for example, SALD-3000J commercially available from Shimadzu Corporation), a value (median diameter (D50)) when a cumulative from the small diameter side is 50% is an average particle size of the light diffusion material. A method of extracting a light diffusion material from the resin composition may be, for example, a method in which the resin composition is diluted in a liquid medium, and a light diffusion material is precipitated and collected according to a centrifugation process or the like.

The average particle size of the light diffusion material in the resin cured product obtained by curing the resin composition containing the light diffusion material can be obtained as an arithmetic average value by calculating equivalent circle diameters (geometric average of the major axis and the minor axis) of 50 particles and observing the particles using a scanning electron microscope.

When the light diffusion material is contained in the resin composition, in order to minimize aggregation of the light diffusion material in the resin composition, the light diffusion material preferably has an organic substance layer containing an organic substance in at least a part of the surface. Examples of organic substances contained in the organic substance layer include organosilane, organosiloxane, fluorosilane, organophosphonate, organophosphate compound, organic phosphinate, organic sulfonic acid compound, carboxylic acid, carboxylic acid ester, derivatives of carboxylic acid, amide, hydrocarbon wax, polyolefin, polyolefin copolymers, polyol, derivatives of polyols, alkanolamine, derivatives of alkanolamines, and organic dispersants.

The organic substance contained in the organic substance layer preferably contains a polyol, an organosilane, or the like, and more preferably contains at least one of a polyol and an organosilane.

Specific examples of organosilanes include octyltriethoxysilane, nonyltriethoxysilane, decyltriethoxy silane, dodecyltriethoxysilane, tridecyltriethoxysilane, tetradecyltriethoxysilane, pentadecyltriethoxysilane, hexadecyltriethoxysilane, heptadecyltriethoxysilane, and octadecyltriethoxysilane.

Specific examples of organosiloxanes include trimethylsilyl group-terminated polydimethylsiloxane (PDMS), polymethylhydrosiloxane (PMHS), and polysiloxanes derived from functionalization (hydrosilylation) of PMHS with olefin.

Specific examples of organophosphonates include, for example, n-octylphosphonic acid and esters thereof, n-decylphosphonic acid and esters thereof, 2-ethylhexylphosphonic acid and esters thereof, and camphylphosphonic acid and esters thereof.

Specific examples of organophosphate compounds include organic acid phosphate, organic pyrophosphate, organic polyphosphate, organic metaphosphate, and their salts.

Specific examples of organic phosphinates include, for example, n-hexylphosphinic acid and esters thereof, n-octylphosphinic acid and esters thereof, di-n-hexylphosphinic acid and esters thereof and di-n-octylphosphinic acid and esters thereof.

Specific examples of organic sulfonic acid compounds include alkyl sulfonic acids such as hexylsulfonic acid, octylsulfonic acid, and 2-ethylhexylsulfonic acid, these alkyl sulfonic acids, and salts of metal ions such as sodium, calcium, magnesium, aluminum, and titanium, and organic ammonium ions such as ammonium ions and triethanolamine.

Specific examples of carboxylic acid include maleic acid, malonic acid, fumaric acid, benzoic acid, phthalic acid, stearic acid, oleic acid, and linoleic acid.

Specific examples of carboxylic acid esters include esters that are generated by a reaction between the above carboxylic acid, and a hydroxy compound such as ethylene glycol, propylene glycol, trimethylolpropane, diethanol amine, triethanolamine, glycerol, hexanetriol, erythritol, mannitol, sorbitol, pentaerythritol, bisphenol A, hydroquinone, and phloroglucinol, and partial esters.

Specific examples of amides include stearic acid amide, oleic acidamide, and erucic acid amide.

Specific examples of polyolefins and their copolymers include copolymers of polyethylene, polypropylene, ethylene, and one or two or more compounds selected from among propylene, butylene, vinyl acetate, acrylate, acrylamide, and the like.

Specific examples of polyols include glycerol, trimethylolethane, and trimethylolpropane.

Specific examples of alkanolamines include diethanol amine and triethanolamine.

Specific examples of organic dispersants include a polymer organic dispersant having a functional group such as citric acid, polyacrylic acid, polymethacrylic acid, anionic, cationic, zwitterionic, nonionic acid, and the like.

When aggregation of the light diffusion material in the resin composition is minimized, the dispersibility of the light diffusion material in the resin cured product tends to be improved.

The light diffusion material may have a metal oxide layer containing a metal oxide in at least a part of the surface. Examples of a metal oxide contained in the metal oxide layer include silicon dioxide, aluminum oxide, zirconia, phosphoria, and boria. The metal oxide layer may be a single layer or two or more layers. When the light diffusion material has two metal oxide layers, it preferably has a first metal oxide layer containing silicon dioxide and a second metal oxide layer containing aluminum oxide.

When the light diffusion material has a metal oxide layer, the dispersibility of the light diffusion material in the resin cured product tends to be improved.

When the light diffusion material has an organic substance layer containing an organic substance and a metal oxide layer, it is preferable that the metal oxide layer and the organic substance layer be provided on the surface of the light diffusion material in the order of the metal oxide layer and the organic substance layer.

When the light diffusion material has an organic substance layer and two metal oxide layers, it is preferable that a first metal oxide layer containing silicon dioxide, a second metal oxide layer containing aluminum oxide and an organic substance layer be provided on the surface of the light diffusion material in the order of the first metal oxide layer, the second metal oxide layer and the organic substance layer (the organic substance layer is the outermost layer).

When the wavelength conversion member contains a light diffusion material, the content of the light diffusion material in the wavelength conversion member (excluding those having a member such as a covering material) with respect to a total amount of the wavelength conversion member is, for example, is preferably 0.1 mass% to 1.0 mass%, more preferably 0.2 mass% to 1.0 mass%, and still more preferably 0.3 mass% to 1.0 mass%.

When the wavelength conversion member contains a resin cured product, the resin cured product may be a product obtained by curing one type of resin composition or a product obtained by curing two or more types of resin compositions. For example, when the wavelength conversion member has a film shape, the wavelength conversion member may be obtained by laminating a first cured product layer obtained by curing a resin composition containing a first quantum dot phosphor and a second cured product layer obtained by curing a resin composition containing a second quantum dot phosphor having different light emission characteristics from the first quantum dot phosphor.

In order to further improve the adhesion, the resin cured product in the wavelength conversion member has a loss tangent (tanδ) measured under conditions of a frequency of 10 Hz and a temperature of 25°C according to dynamic viscoelasticity measurement which is preferably 0.4 to 1.5, more preferably 0.4 to 1.2, and still more preferably 0.4 to 0.6. The loss tangent (tanδ) of the resin cured product can be measured using a dynamic viscoelasticity measurement device (for example, Solid Analyzer RSA-III commercially available from Rheometric Scientific).

In addition, in order to further improve the adhesion, heat resistance, and moisture and heat resistance, the glass transition temperature (Tg) of the resin cured product is preferably 85°C or higher, more preferably 85°C to 160°C, and still more preferably 90°C to 12CPC. The glass transition temperature (Tg) of the resin cured product can be measured using a dynamic viscoelasticity measurement device (for example, commercially available from Rheometric Scientific, Solid Analyzer RSA-III) under a condition of a frequency of 10 Hz.

In addition, in order to further improve the adhesion, heat resistance, and moisture and heat resistance, the resin cured product has a storage elastic modulus measured under conditions of a frequency of 10 Hz and a temperature of 25°C which is preferably 1×10⁷ Pa to 1×10¹⁰ Pa, more preferably 5×10⁷ Pa to 1×10¹⁰ Pa, and still more preferably 5×10⁷ Pa to 5×10⁹ Pa. The storage elastic modulus of the resin cured product can be measured using a dynamic viscoelasticity measurement device (for example, Solid Analyzer RSA-III commercially available from Rheometric Scientific).

The shape of the wavelength conversion member is not particularly limited, and examples thereof include a film shape and a lens shape. When the wavelength conversion member is applied to a backlight unit to be described below, the wavelength conversion member preferably has a film shape.

When the wavelength conversion member has a film shape, the average thickness of the wavelength conversion member is, for example, preferably 50 µm to 500 µm. When the average thickness of the wavelength conversion member is 50 µm or more, the wavelength conversion efficiency tends to be further improved, and when the average thickness is 500 µm or less, if the wavelength conversion member is applied to a backlight unit to be described below, the backlight unit tends to be thinner.

For example, the average thickness of the film-like wavelength conversion member can be obtained as an arithmetic average value of thicknesses at three arbitrary points measured using a micrometer.

### (Covering material)

The wavelength conversion member of the present disclosure may contain a resin cured product containing a quantum dot phosphor and a covering material that covers at least a part of the resin cured product. For example, when the resin cured product has a film shape, one surface or both surfaces of the film-like resin cured product may be covered with a film-like covering material.

In order to minimize decrease in luminous efficiency of the quantum dot phosphor, the covering material preferably has a barrier property against at least one of oxygen and water and more preferably has a barrier property against at least oxygen.

When the wavelength conversion member contains a covering material, the material of the covering material is not particularly limited. For example, a resin may be exemplified. The type of the resin is not particularly limited, and examples thereof include polyesters such as polyethylene terephthalate (PET) and polyethylene naphthalate (PEN), polyolefins such as polyethylene (PE) and polypropylene (PP), polyamides such as nylon, and an ethylene-vinyl alcohol copolymer (EVOH). The covering material may be a material (barrier film) having a barrier layer for improving a barrier function. Regarding the barrier layer, an inorganic layer containing an inorganic substance such as alumina and silica may be exemplified.

The covering material may have a single-layer structure or a multi-layer structure. In the case of the multi-layer structure, a combination of two or more layers having different materials may be used.

For example, the average thickness of the covering material is preferably 20 µm or more, and more preferably 50 µm or more. When the average thickness is 20 µm or more, a function such as a barrier property tends to be sufficient.

The average thickness of the covering material is, for example, preferably 150 µm or less, and more preferably 125 µm or more. When the average thickness is 150 µm 150 µm or less, decrease in light transmittance tends to be minimized.

For example, the average thickness of the covering material is obtained as an arithmetic average value of thicknesses at three arbitrary points measured using a micrometer.

For example, the oxygen permeability of the covering material is preferably 0.5 cm³/(m²·day·atm) or less, more preferably 0.3 cm³/(m²·day·atm) or less, and still more preferably 0.1 cm³/(m²·day·atm) or less.

The oxygen permeability of the covering material can be measured using an oxygen permeability measurement device (for example, OX-TRAN commercially available from MOCON) under conditions of 20°C and a relative humidity of 65%.

The upper limit value of the water vapor permeability of the covering material is not particularly limited, and may be, for example, 1.0×10⁻¹ g/(m²·day) or less.

The water vapor permeability of the covering material can be measured using a water vapor permeability measurement device (for example, AQUATRAN commercially available from MOCON) under an environment of 40°C and a relative humidity of 90%.

In order to further improve light utilization efficiency, the total light transmittance of the wavelength conversion member of the present disclosure is preferably 55% or more, more preferably 60% or more, and still more preferably 65% or more. The total light transmittance of the wavelength conversion member can be measured according to the measurement method of JIS K 7136:2000.

In addition, in order to further improve light utilization efficiency, the haze of the wavelength conversion member of the present disclosure is preferably 95% or more, more preferably 97% or more, and still more preferably 99% or more. The haze of the wavelength conversion member can be measured according to the measurement method of JIS K 7136:2000.

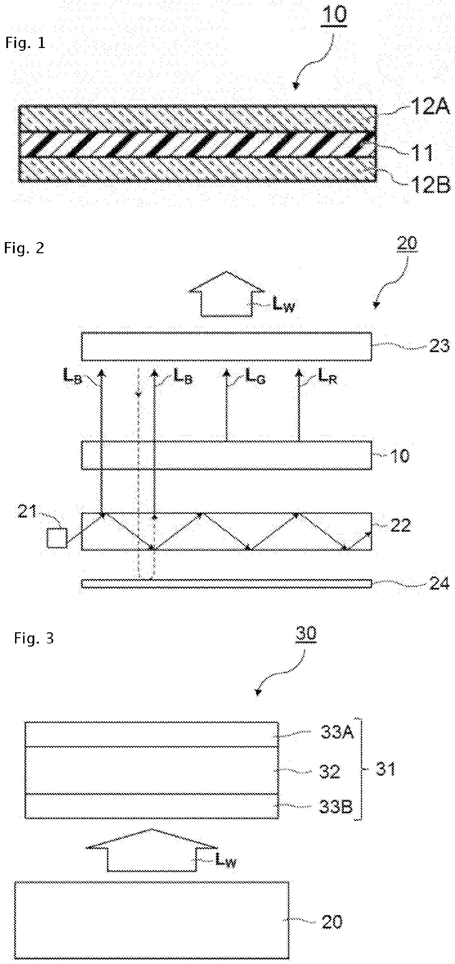

Fig. 1 shows an example of a schematic configuration of the wavelength conversion member. However, the wavelength conversion member of the present disclosure is not limited to the configuration in Fig. 1. In addition, the sizes of the cured product layer and the covering material in Fig. 1 are conceptual, and the relative relationship of the sizes is not limited thereto. Here, in the drawings, the same members are denoted with the same reference numerals and redundant descriptions may be omitted.

A wavelength conversion member 10 shown in Fig. 1 includes a cured product layer 11 as a film-like resin cured product and film-like covering materials 12A and 12B provided on both surfaces of the cured product layer 11. The types and the average thicknesses of the covering material 12A and the covering material 12B may be the same as or different from each other.

The wavelength conversion member having a configuration shown in Fig. 1 can be produced by, for example, the following known production method.

First, a resin composition to be described below is applied to a surface of a film-like covering material (hereinafter referred to as a "first covering material") that is continuously transported to form a coating film. A method of applying a resin composition is not particularly limited, and examples thereof include a die coating method, a curtain coating method, an extrusion coating method, a rod coating method, and a roll coating method.

Next, the film-like covering material (hereinafter referred to as a "second covering material") that is continuously transported is attached to the coating film of the resin composition.

Next, when active energy rays are emitted from the side of the covering material that can transmit active energy rays between the first covering material and the second covering material, a coating film is cured to form a cured product layer. Then, when cutting out into a specified size is performed, the wavelength conversion member having the configuration shown in Fig. 1 can be obtained.

The wavelength and the emission amount of active energy rays can be appropriately set according to the composition of the resin composition. For example, UV rays having a wavelength of 280 nm to 400 nm are emitted at an emission amount of 100 mJ/cm² to 5,000 mJ/cm². Examples of UV sources include a low pressure mercury lamp, an intermediate-pressure mercury lamp, a high pressure mercury lamp, an ultra-high pressure mercury lamp, a carbon arc lamp, a metal halide lamp, a xenon lamp, a chemical lamp, a black light lamp, and a microwave excited mercury lamp.

Here, when neither the first covering material nor the second covering material can transmit active energy rays, active energy rays are emitted to the coating film before the second covering material is attached, and a cured product layer may be formed.

### <Backlight unit>

The backlight unit of the present disclosure includes the above wavelength conversion member of the present disclosure and a light source.

Regarding the light source of the backlight unit, for example, a light source that emits blue light having an emission center wavelength in a wavelength range of 430 nm to 480 nm can be used. Examples of light sources include a light emitting diode (LED) and a laser. When the light source that emits blue light is used, the wavelength conversion member preferably contains at least a quantum dot phosphor that emits red light R and a quantum dot phosphor that emits green light G. Therefore, white light can be obtained from red light and green light emitted from the wavelength conversion member and blue light that has been transmitted through the wavelength conversion member.

In addition, regarding the light source of the backlight unit, for example, a light source that emits ultraviolet light having an emission center wavelength in a wavelength range of 300 nm to 430 nm can be used. Examples of light sources include an LED and a laser. When the light source that emits ultraviolet light is used, the wavelength conversion member preferably contains a quantum dot phosphor R and a quantum dot phosphor G, and also a quantum dot phosphor that emits blue light B excited by excitation light. Therefore, white light can be obtained from red light, green light, and blue light emitted from the wavelength conversion member.

The backlight unit of the present disclosure may be of an edge light type or a direct type.

Fig. 2 shows an example of a schematic configuration of an edge light type backlight unit. However, the backlight unit of the present disclosure is not limited to the configuration in Fig. 2. In addition, the sizes of the members in Fig. 2 are conceptual, and the relative relationship of sizes between the members is not limited thereto.

A backlight unit 20 shown in Fig. 2 includes a light source 21 that emits blue light L_{B}, a light-guiding plate 22 that guides and emits blue light L_{B} emitted from the light source 21, the wavelength conversion member 10 that is arranged to face the light-guiding plate 22, a retroreflective member 23 that is arranged to face the light-guiding plate 22 with the wavelength conversion member 10 therebetween, and a reflective plate 24 that is arranged to face the wavelength conversion member 10 with the light-guiding plate 22 therebetween. The wavelength conversion member 10 emits red light L_{R} and green light L_{G} using a part of the blue light L_{B} as excitation light, and emits the red light L_{R} and the green light L_{G}, and blue light L_{B} that has not become excitation light. According to the red light L_{R}, green light L_{G}, and blue light L_{B}, white light Lw is emitted from the retroreflective member 23.

### <Image display device>

The image display device of the present disclosure includes the above backlight unit of the present disclosure. The image display device is not particularly limited, and examples thereof include a liquid crystal display device.

Fig. 3 shows an example of a schematic configuration of a liquid crystal display device. However, the liquid crystal display device of the present disclosure is not limited to the configuration in Fig. 3. In addition, the sizes of the members in Fig. 3 are conceptual, and the relative relationship of sizes between the members is not limited thereto

A liquid crystal display device 30 shown in Fig. 3 includes the backlight unit 20, and a liquid crystal cell unit 31 that is arranged to face the backlight unit 20. The liquid crystal cell unit 31 has a configuration in which a liquid crystal cell 32 is arranged between a polarization plate 33A and a polarization plate 33B.

The drive method of the liquid crystal cell 32 is not particularly limited, and examples thereof include a twisted Nematic (TN) method, a super twisted nematic (STN) method, a vertical Alignment (VA) method, an in-plane-switching (IPS) method, and an optically compensated birefringence (OCB) method.

### Examples

While the present disclosure will be described below in detail with reference to examples, the present disclosure is not limited to these examples.

### (Preparation of resin composition)

The following components were mixed in formulation amounts (unit: parts by mass) shown in Table 1 to prepare resin compositions. "-" in Table 1 means that the component was not added.
(meth)acrylic compound...tricyclodecane dimethanol diacrylate
(meth)allyl compound...triallyl isocyanurate
Thiol compound 1... pentaerythritol tetrakis(3-mercaptopropionate)
Thiol compound 2... thioether oligomer obtained by mixing 48.69 parts by mass of pentaerythritol tetrakis(3-mercaptopropionate) and 7.27 parts by mass of tris(2-hydroxyethyl)isocyanurate triacrylate and reacting some of thiol groups of pentaerythritol tetrakis(3-mercaptopropionate) with ethylenically unsaturated groups of tris(2-hydroxyethyl)isocyanurate triacrylate

Photopolymerization initiator... 2,4,6-trimethylbenzoyl-diphenyl-phosphine oxide

Light diffusion material... titanium oxide particles (volume average particle size: 0.36 µm) in which a first metal oxide layer containing silicon oxide, a second metal oxide layer containing aluminum oxide and an organic substance layer containing a polyol compound were provided in the order of the first metal oxide layer, the second metal oxide layer and the organic substance layer

Quantum dot phosphor G1... quantum dot phosphor having a core made of CdSe that emits green light and a shell made of ZnS (peak wavelength: 524 nm, half-value width: 30 nm, dispersion medium: amino modified silicone, quantum dot phosphor concentration: 10 mass%)

Quantum dot phosphor G2... quantum dot phosphor having a core made of InP that emits green light and a shell made of ZnS (peak wavelength: 526 nm, half-value width: 38 nm, dispersion medium: isobornyl acrylate, quantum dot phosphor concentration: 10 mass%)

Quantum dot phosphor G3... quantum dot phosphor having a core made of CdSe that emits green light and a shell made of ZnS (peak wavelength: 526 nm, half-value width: 21 nm, dispersion medium: isobornyl acrylate, quantum dot phosphor concentration: 10 mass%)

Quantum dot phosphor G4... quantum dot phosphor having a core made of CdSe that emits green light and a shell made of ZnS (peak wavelength: 526 nm, half-value width: 25 nm, dispersion medium: isobornyl acrylate, quantum dot phosphor concentration: 10 mass%)

Quantum dot phosphor R1...... quantum dot phosphor having a core made of CdSe that emits red light and a shell made of ZnS (peak wavelength: 640 nm, half-value width: 37 nm, dispersion medium: amino modified silicone, quantum dot phosphor concentration: 10 mass%)

Quantum dot phosphor R2... quantum dot phosphor having a core made of InP that emits red light and a shell made of ZnS (peak wavelength: 625 nm, half-value width: 46 nm, dispersion medium: isobornyl acrylate, quantum dot phosphor concentration: 10 mass%)

### (Production of wavelength conversion member)

The resin composition obtained above was applied as a covering material to one surface of a barrier film (PET) having a thickness of 125 µm to form a coating film. The same barrier film as above was arranged on the coating film. Then, UV rays were emitted using a UV irradiation device (commercially available from Eye Graphics Co., Ltd.) (emission amount: 1,000 mJ/cm²), and thus the resin composition was cured to produce a wavelength conversion member.

### (Evaluation of optical properties)

Each of the wavelength conversion members obtained above was cut into a size of 100 mm in width and 100 mm in length to produce a measurement sample. Regarding this sample, an emission spectrum was measured using a brightness meter (PR-655, commercially available from Photo Research). In the brightness meter, a camera unit for recognizing optical properties was installed in the upper part, and a black mask, a brightness enhancement film (BEF) plate, a diffusion plate, and an LED light source were provided under the lens. The measurement sample was set between the BEF plate and the diffusion plate, and an emission peak wavelength, a half-value width, a brightness and a color gamut (Rec2020 coverage according to CIE1931 color coordinates) were calculated from the obtained emission spectrum. The results are shown in Table 1.

### (Measurement of concentration of Cd in resin cured product)

The barrier film of the wavelength conversion member obtained above was peeled off, the resin cured product was taken out, and the concentration of Cd in the resin cured product was measured using an ICP-OES method (using an inductively coupled plasma optical emission spectroscopic device, Agilent5100, commercially available from Agilent Technologies, Inc.).

**[Table 1]**

| | | | Example 1 | Example 2 | Example 3 | Comparative Example 1 | Comparative Example 2 | Comparative Example 3 |
|---|---|---|---|---|---|---|---|---|
| Composition | (Meth)acrylic compound | | 75.4 | 75.4 | 75.4 | 75.4 | - | 75.0 |
| | (Meth)allyl compound | | - | - | - | - | 37.2 | - |
| | Thiol compound 1 | | 18.9 | 18.9 | 18.9 | 18.9 | - | 18.8 |
| | Thiol compound 2 | | - | - | - | - | 55.8 | - |
| | Photopolymerization initiator | | 0.5 | 0.5 | 0.5 | 0.5 | 0.5 | 0.5 |
| | Light diffusion material | | 0.7 | 0.7 | 0.7 | 0.7 | - | 0.7 |
| | Quantum dot phosphor G1 | | - | - | - | - | 4.5 | - |
| | Quantum dot phosphor G2 | | - | - | 0.6 | 1.3 | - | 2.5 |
| | Quantum dot phosphor G3 | | 2.5 | - | - | - | - | - |
| | Quantum dot phosphor G4 | | - | 2.5 | 1.9 | 1.2 | - | - |
| | Quantum dot phosphor R 1 | | - | - | - | - | 1.5 | - |
| | Quantum dot phosphor R2 | | 2.0 | 2.0 | 2.0 | 2.0 | - | 2.0 |
| Evaluation | Green light | Peak wavelength | 528 nm | 528 nm | 528 nm | 528 nm | 529 nm | 533 nm |
| | | FWHM-G | 22 nm | 25 nm | 29 nm | 32 nm | 31 nm | 40 nm |
| | Red light | Peak wavelength | 630 nm | 630 nm | 630 nm | 630 nm | 643 nm | 629 nm |
| | | FWHM-R | 46 nm | 46 nm | 46 nm | 46 nm | 38 nm | 45 nm |
| | Concentration of Cd in resin | | 80 ppm | 80 ppm | 60 ppm | 40 ppm | 500 ppm | 0 ppm |
| | Rec2020 coverage | | 89.6% | 88.6% | 87.2% | 82.0% | 87.0% | 76.2% |
| | Brightness | | 1,460 | 1,520 | 1,570 | 1,510 | 1,360 | 1,500 |

As shown in Table 1, the wavelength conversion members of Examples 1 to 3 in which the half-value width of the emission wavelength peak of green light was 30 nm or less had a high Rec2020 coverage and brightness in the evaluations even if the concentration of Cd was 100 ppm or less, and had a better excellent balance between color reproducibility and brightness than the wavelength conversion members of Comparative Examples 1 to 3 in which the half-value width of the emission wavelength peak of green light exceeded 30 nm.

All references, patent applications, and technical standards described in this specification are incorporated herein by reference to the same extent as if it were specifically and individually noted that the individual references, patent applications, and technical standards are incorporated by reference.

### Reference Signs List

- 10: Wavelength conversion member
- 11: Cured product layer
- 12A: Covering material
- 12B: Covering material
- 20: Backlight unit
- 21: Light source
- 22: Light-guiding plate
- 23: Retroreflective member
- 24: Reflective plate
- 30: Image display device
- 31: Liquid crystal cell unit
- 32: Liquid crystal cell
- 33A: Polarization plate
- 33B: Polarization plate
- L_{B}: Blue light
- L_{R}: Red light
- L_{G}: Green light
- L_{W}: White light

## Claims

1. A wavelength conversion member which comprises a quantum dot phosphor and is able to convert incident light into a green light and a red light, in which a half-value width of a green light emission spectrum (FWHM-G) is 30 nm or less.

2. The wavelength conversion member according to claim 1, wherein a concentration of Cd is 100 ppm or less.

3. A wavelength conversion member which comprises a quantum dot phosphor containing Cd and is able to convert incident light into a green light and a red light, in which a half-value width of a green light emission spectrum (FWHM-G) is 30 nm or less, and a concentration of Cd is 100 ppm or less.

4. The wavelength conversion member according to any one of claims 1 to 3, wherein the half-value width of a red light emission spectrum (FWHM-R) is 40 nm or more.

5. The wavelength conversion member according to any one of claims 1 to 4, wherein a peak wavelength of the green light emission spectrum is in a range of 530±20 nm, and a peak wavelength of a red light emission spectrum is in a range of 630±20 nm.

6. The wavelength conversion member according to any one of claims 1 to 5, wherein the quantum dot phosphor comprises a quantum dot phosphor that emits green light and a quantum dot phosphor that emits red light, the quantum dot phosphor that emits green light comprises a compound containing Cd, and the quantum dot phosphor that emits red light comprises a compound containing In.

7. The wavelength conversion member according to any one of claims 1 to 6, further comprising a resin cured product.

8. The wavelength conversion member according to claim 7, further comprising a covering material that covers at least a part of the resin cured product.

9. The wavelength conversion member according to claim 8, wherein the covering material has a barrier property against at least one of oxygen and water.

10. A backlight unit comprising the wavelength conversion member according to any one of claims 1 to 9 and a light source.

11. An image display device comprising the backlight unit according to claim 10.
